# EUROPÄISCHE PATENTSCHRIFT

(11) **EP 0 406 763 B1**
(45) Veröffentlichungstag und Bekanntmachung des Hinweises auf die Patenterteilung: **10.11.1993**
(21) Anmeldenummer: 90112594.8
(22) Anmeldetag: 02.07.1990
(51) Int. Cl.: H05K 7/20

(54) **Schwenkbare Kühleinrichtung für planare elektronische Baugruppen**
Swinging cooling device for planar electronic unit
Dispositif de refroidissement pivotable pour ensembles électroniques plats

(30) Priorität: 07.07.1989 DE 8908325 U
(43) Veröffentlichungstag der Anmeldung: 09.01.1991
(73) Patentinhaber: Siemens Nixdorf Informationssysteme Aktiengesellschaft, 33102 Paderborn (DE)
(72) Erfinder: Schmalzl, Dieter, D-8900 Augsburg (DE); Hellwig, Bernard, Ing., D-8034 Germering (DE); Sotiriu, Cornelius, Dipl.-Ing., D-8900 Augsburg 16 (DE)
(74) Vertreter: Fuchs, Franz-Josef, Dr.-Ing.

(56) Entgegenhaltungen:
- FR-A- 1 147 644
- PROCEEDINGS OF THE 1989 JAPAN IEMT SYMPOSIUM 26 April 1989, Nara, JP; Seiten 83 - 89; WESSELY: "Packaging system for high performance computer"

## Beschreibung

Die Erfindung betrifft eine schwenkbare Kühleinrichtung mit kühlmitteldurchflossener Kühlplatte für planare elektronische Baugruppen, der das Kühlmittel über Leitungen zugeführt ist, bei der die Leitungen aus flexiblen, kreisbogenförmig verformbaren Schläuchen bestehen, die in den Scharnieren für die Schwenkbewegung eingebettet sind.

Für laufzeitoptimierte, planar mit Baugruppen bestückte, stark verdichtete elektronische Platterfunktionseinheiten mit hoher Verlustleistung wird die anfallende Wärme mit flüssigkeitsdurchflossenen Kühlplatten abgeführt. Diese Kühlplatten müssen zu Wartungszwecken und zum Baugruppentausch vor dem Baugruppenfeld abgeschwenkt werden.

Der Flüssigkeitskreis soll dabei nicht aufgetrennt werden, so daß die Kühlmittelzu- bzw. -ableitung aus dem erforderlichen Kühlaggregat flexibel an diese Kühlplatte geführt werden muß. Dabei ist zu beachten, daß die Kühlplattenaufhängung platzsparend, toleranzunanfallig und ohne Zug-, Druck- oder Torsionsbelastung der kühlmittelführenden Leitungen ausgeführt ist. Wegen der Gefahr von Leckstellen an den Verbindungsstellen der kühlmittelführenden Teile ist größtmögliche Dichtheit erforderlich.

Es ist zudem für die Ableitung statischer Aufladungen einzelner Einheiten zu sorgen, um Schädigungen der Bausteine zu vermeiden.

Umlaufend an der Kühlplatte ist ein Maximum an Steckerplätzen vorgesehen, welche mit einfachen Werkzeugen direkt von vorne zugänglich und bedienbar sind. Die Leitungsführung der umlaufend angebrachten Stecker muß berücksichtigt werden.

Aufgabe der vorliegenden Erfindung ist es, eine Kühleinrichtung für planare elektronische Baugruppen, insbesondere der Datentechnik zu schaffen, die bei minimaler mechanischer Beanspruchung der Kühlmittelzuführungsleitungen ein Ausschwenken der Kühlvorrichtung ohne Unterbrechung des Kühlmittelzuflusses gestattet.

Zur Lösung dieser Aufgabe wird die schwenkbare Kühleinrichtung gemäß der Erfindung derart ausgebildet, daß der Drehpunkt für die Scharniere so gelegt ist, daß der dem Beginn des Schlauchbogens auf seiner neutralen Phase bezeichnende erste Punkt und der das Ende des Schlauchbogens im zugeklappten Zustand der Kühleinrichtung angebende zweite Punkt und der diesem zweiten Punkt im um 90° aufgeklappten Zustand der Kühleinrichtung entsprechende Punkt gleichweit vom Drehpunkt entfernt ist.

Unter der neutralen Phase ist dabei die im Zentrum des jeweiligen Schlauches verlaufende gedachte Mittellinie zu verstehen.

Durch diese Maßnahmen wird die Länge des Schlauches und die Lage des Drehpunktes für die Scharniere so aufeinander abgestimmt, daß in keinem Bewegungszustand beim Schwenkvorgang, Zug-, Druck- oder Torsionskräfte auf die Schlauchleitung einwirken können.

Dabei kann der flexible Schlauch ein Metallwellschlauch sein. Dieser erfüllt neben anderem auch die Forderung metallischer Verbindung zwischen den Bauteilen zur elektrostatischen Ableitung.

Die Schlauchleitung ist dabei im Scharnier eingebettet und über Eck durch speziell geformte Anschlußstücke in die als Kühlplatte ausgebildete Kühleinrichtung eingeleitet. Dadurch ist umlaufend an der Kühlplatte ein Maximum an Steckplätzen anordenbar und die Stecker können von vorn mit einfachen Werkzeugen bedient werden.

Das bewegliche Teil des Scharniers ist U-bügelförmig ausgebildet. Dadurch können Leitungen mit Steckern sowohl bei geschlossener als auch bei offener Kühlplatte montiert werden. Ferner werden die Leitungen in dafür vorgesehenen Bereichen des Scharniers so geführt, daß vor dem Aufschwenken ein Ziehen der Stekker nicht erforderlich ist.

Anhand der Ausführungsbeispiele nach den FIG 1 bis 3 wird die Neuerung näher erläutert.

Es zeigen
FIG 1 einen Ausschnitt aus einer Aufnahmevorrichtung für planare elektronische Baugruppen der Datentechnik mit einer kühlmitteldurchflossenen Kühlplatte im eingeschwenkten Zustand,
FIG 2 eine Draufsicht der Anordnung nach FIG 1 in drei verschiedenen Schwenkwinkeln,
FIG 3 die Konstruktionszeichnung zur Ermittlung des Drehpunktes des Scharniers.

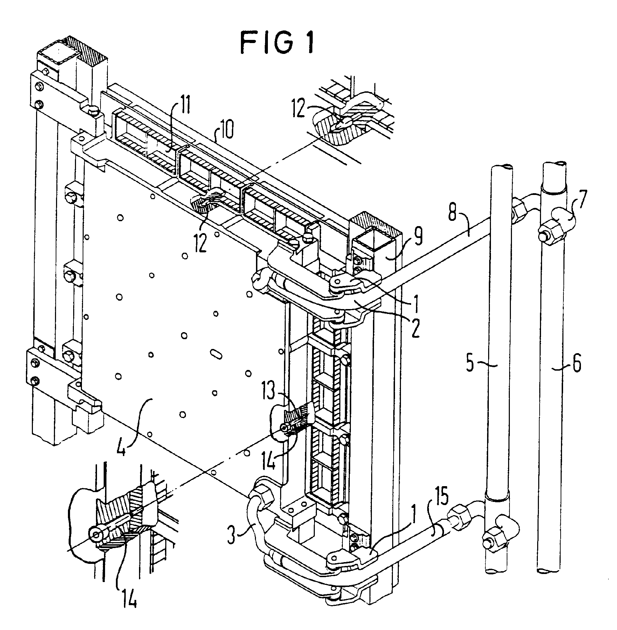

FIG 1 zeigt eine sogenannte Platterfunktionseinheit, wobei die planaren elektronischen Baugruppen durch die sie kühlende Kühlplatte 4 verdeckt sind und nur der Platter 10 auf der Rückseite der Funktionseinheit erkennbar ist. Die Platterfunktionseinheiten sind in einem Datenschrank an den Holmen 9 übereinander angeordnet und die nicht sichtbaren planaren Baugruppen werden über die mit Kühlmittel durchflossene Kühlplatte 4, die wiederum vollflächig auf den planaren Elektronikbaugruppen im eingeschwenkten Zustand aufliegt, gekühlt. Das Kühlmittel selbst wird über die Steigleitungen 5 und 6 und die jeweiligen Zuleitungen 15 an die Kühlplatte herangeführt und über die Ableitung 8 wieder der Steigleitung zugeführt. Rund um die Kühlplatte sind Steckfassungen 11 angebracht, in die entsprechende Leitungsstecker, die die einzelnen Funktionseinheiten untereinander verbinden, eingesteckt werden können. Die vorgesehenen Dichtungen der Schlauchverbindungen am jeweiligen Ende des Schlauches erfolgen über einen 24°-Konus als Metallringdichtung und zusätzlich über einen im Konusbereich dichten O-Ring. Das Scharnier 1 für die Kühlplatte ist so ausgeführt, daß es flächig am senkrechten Einbauholm 9 und flächig an den Stirnseiten der Kühlplatte 4 aufgeschraubt ist. Dadurch wird auf einfache Weise ein Größtmaß an Toleranzausgleich möglich. Ferner ist nach dem Einjustieren der Kühlplatte trotz der hohen Gewichte sichergestellt, daß keine mechanischen Spannungen auf die empfindlichen elektronischen Komponenten wirken. Im eingeschwenkten Zustand wird die Kühlplatte auf die nicht sichtbaren planaren elektrischen Baugruppen aufgeschraubt, so daß ein inniger Kontakt zum Wärmeaustausch vorhanden ist. Über kegelige Bolzen 12 in der Platterfunktionseinheit und Bohrungen in der Kühlplatte 4 erfolgt nach dem Zuschwenken eine Vorjustierung der Platterfunktionseinheit zur Kühlplatte. Anschließend wird über zwei Konusbohrungen 13 in der Kühlplatte 4 und zwei Verbindungsschrauben mit Konus 14 zwischen Kühlplatte und Platterfunktionseinheit eine Feinjustierung durchgeführt, bevor die Kühlplatte mit den übrigen Teilen der Platterfunktionseinheit fest zusammengeschraubt wird. Durch das stufenförmige Absetzen der Scharniere 1 lassen sich an dieser Stelle leicht Leitungen zuführen. Außerdem sorgt die U-bogenförmige Ausbildung des Scharniers dafür, daß sowohl im ausgeschwenkten Zustand der Kühlplatte als auch im eingeschwenkten Zustand der Kühlplatte die gesteckten Leitungen in diesem Zustand verbleiben können.

Die Steigleitungen 5 und 6 dienen für weitere Platterfunktionseinheiten als Kühlmittelzuführungsleitung, wobei das Kühlmittel am Stutzen 7 in eine spiegelbildlich ausgebildete Kühlplatte eingeleitet werden kann.

Eine solche Platterfunktionseinheit ist in der Zeitschrift "Proceedings of the 1989 Japan IEMT" Symposium 26. April 1989, Seiten 83 bis 88, beschrieben.

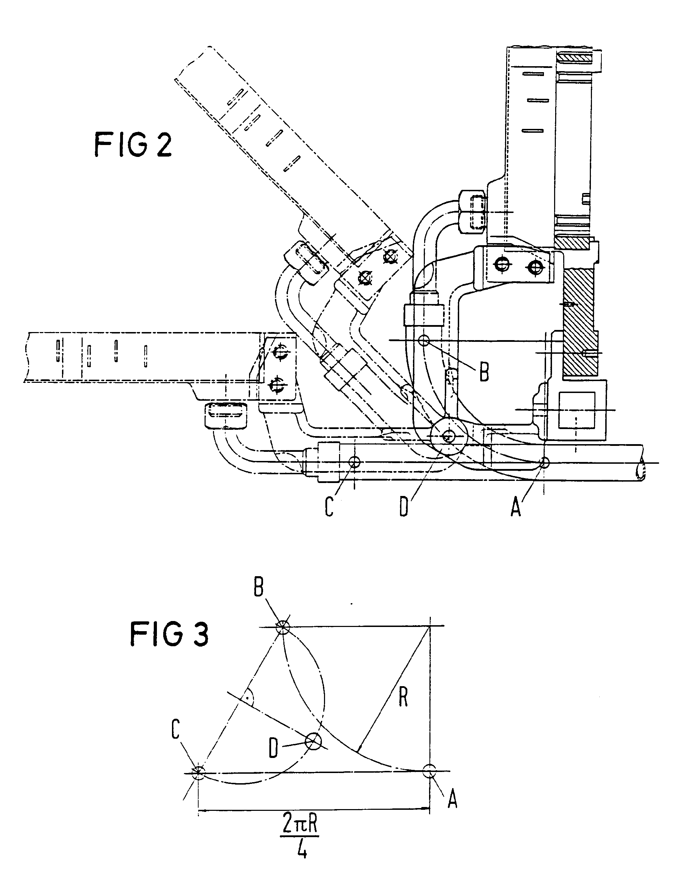

Wie in FIG 2 in einer Draufsicht dargestellt, ist die Bewegung der flexiblen Schläuche, die zwischen dem Kühlmittelzulauf und dem Anschluß an die Kühlplatte vorgesehen sind, in verschiedenen Schwenkphasen der Kühlplatte dargestellt. Wichtig für die Auswahl des Drehpunktes des Scharniers ist es, daß der flexible Schlauch keine Zug-, Druck- oder Torsionsbelastung erhält. Die Kühlplatte ist im eingeschwenkten, im halb eingeschwenkten und im voll ausgeschwenkten Zustand gezeichnet, wobei man ersehen kann, daß die Schlauchbiegung durch den Drehpunkt des Scharniers hindurch wandert, so daß dadurch die oben genannten schädlichen Beanspruchungen des Schlauches vermieden werden.

Das Scharnier ist dabei so angeordnet, daß die in FIG 3 dargestellten Punkte A, B und C gleich weit von dem Punkt D entfernt sind, wobei der Punkt D der Drehpunkt des Scharniers, der Punkt A den Anfang des Schlauchbogens, der Punkt B das Ende des Schlauchbogens bei vollem Einschwenken und der Punkt C das Ende des Schlauchbogens bei vollem Ausschwenken angibt. Der Drehpunkt D wird dadurch gefunden, daß ein Kreisbogen über die gedachte Strecke BC geschlagen und die Mittelsenkrechte der Strecke BC errichtet wird. Am Schnittpunkt beider liegt der gewünschte Punkt D, der zugleich auch erhalten werden könnte, wenn die Mittelsenkrechte auf der Strecke AC errichtet wird. Dadurch ergibt sich eine von allen Eckpunkten des gedachten Dreiecks A, B, C gleich weit entfernter Drehpunkt D.

## Patentansprüche

1. Schwenkbare Kühleinrichtung mit kühlmitteldurchflossener Kühlplatte (4) für planare elektronische Baugruppen, der das Kühlmittel über Leitungen zugeführt ist, bei der die Leitungen aus flexiblen, kreisbogenförmig verformbaren Schläuchen (15,8) bestehen, die in den Scharnieren (1) für die Schwenkbewegung eingebettet sind, **dadurch gekennzeichnet,** daß der Drehpunkt (D) für die Scharniere (1) so gelegt ist, daß der den Beginn des Schlauchbogens (2) auf seiner neutralen Phase bezeichnende erste Punkt (A) und der das Ende des Schlauchbogens im zugeklappten Zustand der Kühleinrichtung angebende zweite Punkt (B) und der diesem zweiten Punkt (B) im um 90° aufgeklappten Zustand der Kühleinrichtung entsprechende Punkt (C) gleichweit vom Drehpunkt (D) entfernt sind.

2. Schwenkbare Kühleinrichtung nach Anspruch 1, **da****durch gekennzeichnet,** daß der flexible Schlauch ein Metallwellschlauch ist.

3. Schwenkbare Kühleinrichtung nach einem der vorhergehenden Ansprüche, **dadurch gekennzeichnet,** daß die Schlauchleitung im Scharnier (1) eingebettet und über Eck durch speziell geformte Anschlußstücke (3) in die als Kühlplatte (4) ausgebildete Kühlvorrichtung eingeleitet wird.

4. Schwenkbare Kühleinrichtung nach einem der vorhergehenden Ansprüche, **dadurch gekennzeichnet,** daß der bewegliche Teil des Scharniers U-bügelförmig ausgebildet ist.

## Claims

1. Hinged cooling device comprising cooling plate (4) with coolant flowing through it for planar electronic assemblies, to which cooling device the coolant is fed via pipes and in which cooling device the pipes comprise flexible, arcuate, deformable hoses (15, 8) which are embedded in the hinges (1) for the swivel movement, characterised in that the pivot point (D) for the hinges (1) is sited in such a way that the first point (A), denoting the start of the hose arc (2) in its neutral phase and the second point (B) denoting the end of the hose arc in the closed state of the cooling device and the point (C) corresponding to this second point (B) in the state in which the cooling device is opened through 90° are equidistant from the pivot point (D).

2. Hinged cooling device according to Claim 1, characterised in that the flexible hose is a corrugated metal hose.

3. Hinged cooling device according to one of the preceding claims, characterised in that the hose pipe is embedded in the hinge (1) and is introduced diagonally by means of specially shaped connecting pieces (3) into the cooling device, which is designed as cooling plate (4).

4. Hinged cooling device according to one of the preceding claims, characterised in that the movable part of the hinge is of stirrup-bracket shape.

## Revendications

1. Dispositif de refroidissement basculant comportant une plaque (4) dans laquelle passe un fluide de refroidissement, qui est destiné à refroidir des modules électroniques planar et à laquelle le fluide de refroidissement est amené par des conduits, les conduits étant formés de tuyaux souples (15;8), déformables en arc de cercle et insérés dans les charnières (1) pour le mouvement de basculement, caractérisé par le fait que le centre de rotation (D) des charnières (1) est disposé de sorte que le premier point (A), qui marque le début de l'arc (2) du tuyau dans sa phase neutre, et le deuxième point (B), qui marque la fin de l'arc du tuyau lorsque le dispositif de refroidissement est complètement rabattu, et le point (C), qui correspond à ce deuxième point (B) lorsque le dispositif de refroidissement est relevé à 90°, sont équidistants du centre de rotation (D).

2. Dispositif de refroidissement basculant suivant la revendication 1, caractérisé en ce que le tuyau souple est un tuyau métallique ondulé.

3. Dispositif de refroidissement basculant suivant l'une des revendications précédentes, caractérisé en ce que le conduit en forme de tuyau souple est inséré dans la charnière (1) et pénètre, en un sommet, au moyen d'éléments de raccordement (3) ayant une forme spéciale, dans le dispositif de refroidissement constitué sous la forme d'une plaque de refroidissement (4).

4. Dispositif de refroidissement basculant suivant l'une des revendications précédentes, caractérisé en ce que la partie mobile de la charnière est constituée sous la forme d'un étrier en forme de U.
